# EUROPÄISCHE PATENTSCHRIFT

(11) **EP 2 537 251 B1**
(45) Veröffentlichungstag und Bekanntmachung des Hinweises auf die Patenterteilung: **30.03.2016**
(21) Anmeldenummer: 11702928.0
(22) Anmeldetag: 19.01.2011
(51) Int. Cl.: H03H 11/04, H03H 7/01

(54) **SCHALTBARES BANDPASSFILTER**
SWITCHABLE BANDPASS FILTER
FILTRE PASSE-BANDE COMMUTABLE

(30) Priorität: 18.02.2010 DE 102010008483
(43) Veröffentlichungstag der Anmeldung: 26.12.2012
(73) Patentinhaber: Rohde & Schwarz GmbH & Co. KG, 81671 München (DE)
(72) Erfinder: SCHICK, Michael, 71554 Weissach Im Tal (DE); KASTE, Norbert, 71522 Backnang (DE)
(74) Vertreter: Beder, Jens
(86) Internationale Anmeldenummer: PCT/EP2011/000201
(87) Internationale Veröffentlichungsnummer: WO 2011/101075

(56) Entgegenhaltungen:
- US-A- 4 672 337
- US-A- 5 361 050
- US-A1- 2003 042 992
- KHOLODNYAK D V ET AL: "Bandpass Filters for Ka-Band Satellite Communication Applications Based on LTCC", MICROWAVE CONFERENCE, 2008. EUMC 2008. 38TH EUROPEAN, IEEE, PISCATAWAY, NJ, USA, 27. Oktober 2008 (2008-10-27), Seiten 211-214, XP031407132, ISBN: 978-2-87487-006-4

## Beschreibung

Die Erfindung betrifft ein schaltbares Bandpassfilter. Insbesondere betrifft die Erfindung ein über ein breites Frequenzband schaltbares schmalbandiges Bandpassfilter mit zwei Filterelementen in Mikrostreifenleitungstechnik, geeignet zum Einsatz als sog. Cosite-Filter in einer kompakten, für die Serienfertigung besonders geeigneten und im Betrieb robusten Bauform.

In der Funkkommunikationstechnik werden in zunehmenden Umfang Frequenzsprungverfahren eingesetzt. Die Trägerfrequenz der Übertragungstrecke wechselt hier in schneller, in Sender und Empfänger bekannter Folge. Daraus leitet sich für die verwendeten Sender und Empfänger der Bedarf an in der Frequenz einstellbaren, schmalbandigen Filtern für die genutzten Frequenzbereiche ab. Diese Filter müssen eine schnelle Einstellbarkeit der Mittenfrequenz und möglichst digitale Schaltmöglichkeit in einer von der Anwendung abgeleiteten feinen Frequenzauflösung bereitstellen.

Mobile Kommunikationsgeräte weisen zudem in enger Nachbarschaft Sende- und Empfangsbaugruppen auf, häufig sind noch dazu im Umfeld eine Vielzahl von Kommunikationsgeräten im selben Frequenzband zugleich aktiv. Hier ist es von Vorteil, wenn dasselbe Filter als Empfangsfilter zur Selektion des gewünschten Empfangssignals und Ausfiltern von über die Empfangsantenne einwirkenden Störungen als auch als Sendefilter zur Verminderung unerwünschter Ausstrahlungen zum Einsatz kommen kann. Ein solches Filter wird als Cosite-Filter bezeichnet und muss zusätzlich in der Lage sein, eine entsprechende Sendeleistung bei geringer Einfügedämpfung zu übertragen und einerseits Signale in Vorwärtsrichtung von Verstärker zu Antenne und andererseits in Rückwärtsrichtung von Antenne zu Empfänger zu filtern.

Stand der Technik ist die Realisierung solcher Filter als zweikreisige Resonatorfilter bestehend aus zwei Resonatoren mit hoher Güte, gekoppelt über ein Netzwerk aus Kapazitäten und/oder Induktivitäten. Das Dokument US-A-5 361 050 offenbart eine solche Scholtung. Die Frequenzabstimmung erfolgt über mittels Halbleiterdioden zuschaltbare Kapazitäten. Dabei sind die Resonatoren in der Regel Spulenresonatoren hoher Güte (insbesondere Luftspulen), die Frequenzeinstellung erfolgt mittels PIN-Dioden zuschaltbarer Kondensatoren. Die Kombination der Spulenresonatoren hoher Güte und die Verwendung von PIN-Dioden ermöglicht das Übertragen entsprechend hoher Sendeleistungen.

Der geschilderte Aufbau weist allerdings eine Reihe von Nachteilen auf. Die Verwendung zweier Spulenresonatoren führt zu großen mechanischen Abmessungen und großer Masse und dementsprechenden Nachteilen bei Festigkeit des Filters gegenüber Rüttel- und Schüttelbelastungen sowie großen Abmessungen der gesamten Filterbaugruppe. Eine auf dieser technischen Basis realisierte Filterbaugruppe stellt bei der Integration in mobile Geräte entsprechend ungünstige Anforderungen. Darüber hinaus ist ein Bandpassfilter mit zwei Spulenresonatoren in Herstellung, Abgleich und im Betrieb von weiteren Nachteilen begleitet. Zum einen ist ein entsprechender Filteraufbau für eine automatische Fertigung in den auf oberflächenmontierte Bauelemente (engl. Surface Mounted Devices, abgekürzt SMD) und Wiederaufschmelz-Lötverfahren (engl. reflow soldering) ausgelegten Fertigungslinien nicht vollständig automatisiert möglich, sondern erfordert auch Schritte in Handfertigung. Zusätzlich sind beide Spulenresonatoren in einem schwierigen Abgleichschritt exakt aufeinander abzugleichen, um eine entsprechende konstant flache Filterübertragungsfunktion im Durchlassbereich zu erreichen. Ein solcherart realisiertes abstimmbares

Bandpassfilter ist komplex aufgebaut und in der Fertigung aufwendig.

Es ist daher die Aufgabe zu lösen, ein über einen breiten Frequenzbereich schaltbares, schmalbandiges Bandpassfilter für den UHF-/VHF-Bereich zu schaffen, das die genannten Nachteile des Standes der Technik vermeidet.

Das erfindungsgemäße schaltbare Bandpassfilter nach Anspruch 1 löst diese Aufgabe in vorteilhafter Weise.

Das schaltbare Bandpassfilter nach Anspruch 1 umfasst dazu ein erstes Filterelement und ein zweites Filterelement, die über eine schaltbare Koppelvorrichtung miteinander verbunden sind. Das Bandpassfilter ist dadurch gekennzeichnet, dass das erste und das zweite Filterelement aus jeweils in einer Ebene flächig ausgebildeten Leiterstrukturen bestehen und das erste und das zweite Filterelement jeweils mindestens zwei Leitungsabschnitte umfassen. Neben der Kopplung über die schaltbare Koppelvorrichtung zur Realisierung des schaltbaren Bandpassfilters stehen das erste und das zweite Filterelement in elektromagnetischer Wechselwirkung miteinander.

Diese direkte Wechselwirkung des ersten und zweiten Filterelementes sorgt für eine geringe Baugröße des gesamten Bandpassfilters und wird durch das Fehlen von weiteren etwa mit Masse verbundenen Leiterelementen zwischen dem ersten und dem zweiten Filterelement erreicht. Das erste und das zweite Filterelement sind daher, wenn auch beabstandet unmittelbar benachbart zueinander aufgebaut. Die Realsierung des ersten und des zweiten Filterelements in Form zweikreisiger Resonatorfilter in Mikrostreifenleitungstechnik ermöglicht den Aufbau des Bandpassfilters in mehrlagiger Leiterplattentechnik und ist damit effizient und zu geringen Kosten herzustellen. Die Mikrostreifenleitungen sind dabei an einem Ende kurzgeschlossen. Zusätzlich ist geringe Gesamtmasse des Bandpassfilters und die Verteilung der Massen des erfindungsgemäßen Bandpassfilters für den Einsatz in mobilen Kommunikationsgeräten besonders geeignet. Ebenso ermöglicht der Aufbau in Mikrostreifenleitungstechnik einen geringen Temperaturkoeffizienten und damit den Verzicht auf eine spezielle Temperaturkompensation oder Nachstimmen des Filters im Betrieb über einen weiten Temperaturbereich von -30°C bis +80°C.

In weiteren Unteransprüchen sind besonders bevorzugte Ausführungen der Erfindung ausgeführt.

Insbesondere ist es vorteilhaft, wenn die Koppelvorrichtung aus einem Netzwerk, gebildet aus Kondensatoren und/oder Induktivitäten und HalbleiterDioden besteht. Für als Schaltelemente einzusetzende Halbleiterdioden sind für die Übertragung höherer Leistung insbesondere PIN-Dioden geeignet, es können allerdings bei geringeren Leistungen auch Varaktordioden zum Einsatz gelangen.

Besonders bevorzugt ist eine raumsparende Realisierung des Bandpassfilters auf mehrlagigen Leiterplatten, wobei auf einer oder mehreren Lagen der Leiterplatte das erste und das zweite Filterelement in Mikrostreifenleitungstechnik aufgebracht sein können und auf einer oder weiteren Lagen die Koppelvorrichtung realisiert wird. Das Bandpassfilter kann auch in geeigneter Weise so aufgebaut werden, dass der Eingangsanschluss des Bandpassfilters an einem geeignet ausgebildeten Abschnitt des ersten Filterelements und der Ausgangsanschluss an einem geeignet ausgebildeten Abschnitt des zweiten Filterelements ausgebildet wird. Darüber hinaus kann in einer bevorzugten Ausführungsform des erfindungsgemäßen Bandpassfilters das Koppelnetzwerk so ausgebildet sein, dass die dem ersten und dem zweiten Filterelement zuschaltbaren Kondensatoren gleich groß sind. Damit ist in geeigneter Weise erreicht, dass das Filter in Vorwärtsrichtung (Sendefilter) wie in Rückwärtsrichtung (Empfangsfilter) mit gleichen Eigenschaften betrieben werden kann. Dies setzt voraus, dass erstes und zweites Filterelement in zueinander symmetrischer Weise aufgebaut sind. Durch die Verwendung der Streifenleitertechnik ist die Gleichheit der Resonatoren zu gewährleisten.

Das Bandpassfilter zeigt damit an Ein- und Ausgang zueinander symmetrisches Verhalten.

Wird das Bandpassfilter in Form von Leitungsabschnitten realisiert, so ist es günstig, die Leitungsabschnitte des ersten und des zweiten Filterelements zueinander so zu führen, dass einerseits Leitungsabschnitte parallel zueinander liegen, um eine direkte Kopplung zwischen erstem und zweitem Filterelement auf parallelen Abschnitten zu erreichen und weiter der Flächenbedarf für die Filterelemente und das gesamte Bandpassfilter möglichst gering zu halten.

In einer weiteren, besonders geeigneten Ausführungsform des Bandpassfilters bestehen das erste und das zweite Filterelement aus jeweils zueinander parallelen Leitungsabschnitten, die abwechselnd angeordnet sind und an einem Ende leitend miteinander verbunden sind. Besonders vorteilhaft ist, wenn das erste und das zweite Filterelement jeweils mit mindestens einem weiteren Leitungsstück verbunden sind, das zur Abstimmung des jeweiligen Filterelements ausgebildet ist. Damit ist in einfacher weise ein exakter Abgleich des ersten und des zweiten Filterelements bezüglich ihrer Filtermittenfrequenz möglich, sofern ein solcher erforderlich ist. Damit kann eine optimale Flachheit der Filterübertragungsfunktion im Durchlassbereich erreicht werden. Besonders günstig für einen geringen Raumbedarf des Bandpassfilters und für die unmitttelbare elektromagnetische Wechselwirkung zwischen erstem Filterelement und zweitem Filterelement ist ein Aufbau der parallelen Leitungsabschnitte des ersten Filterelements einerseits und des zweiten Filterelements andererseits auf unterschiedlichen Lagen der verwendeten Leiterplatte.

Das erfindungsgemäße Bandpassfilter wird im Folgenden anhand der Figuren näher erläutert. Es zeigen:
- Fig. 1: ein Blockschaltbild des hochfrequenten Anteils eines Kommunikationssystems mit Frequenzsprungverfahren unter Verwendung eines erfindungsgemäßen Bandpassfilters,
- Fig. 2: einen vereinfachten Aufbau eines über einen weiten Frequenzbereich abstimmbaren Bandpassfilters nach vorliegender Erfindung,
- Fig. 3: ein einfaches Blockschaltbild für ein erfindungsgemäßes Bandpassfilter für den VHF-Bereich,
- Fig. 4: den Aufbau und die erfindungsgemäße Anordnung der Resonatoren für ein erfindungsgemäßes Bandpassfilter für den VHF-Bereich,
- Fig. 5: simulierte S-Parameter für ein erfindungsgemäßes Bandpassfilter für den VHF-Bereich für eine Abweichung von der Mittefrequenz von f_{ctr}= +/-8%, und PIN_0, IN_1, PIN_2, PIN_3, PIN_4 und PIN_5 auf "ON",
- Fig. 6: simulierte S-Parameter für ein erfindungsgemäßes Bandpassfilter für den VHF-Bereich für eine gegenüber Fig. 5 geänderten Mittenfrequenz bei geänderter Einstellung der PIN-Dioden,
- Fig. 7: simulierte S-Parameter für ein erfindungsgemäßes Bandpassfilter für den VHF-Bereich für eine Abweichung von der Mittefrequenz von f_{ctr}= +/-8%, und PIN_0, PIN_1 auf "ON",
- Fig. 8: ein einfaches Blockschaltbild eines erfindungsgemäßen schaltbaren Bandpassfilters für den UHF-Bereich,
- Fig. 9: einen Aufbau und die erfindungsgemäße Anordnung der Resonatoren für ein erfindungsgemäßes Bandpassfilter für den UHF-Bereich, und
- Fig. 10: simulierte S-Parameter für ein erfindungsgemäßes Bandpassfilter für den UHF-Bereich für eine Abweichung von der Mittefrequenz von f_{ctr}= +/-8%, und PIN_0, IN_1 und PIN_2 auf "ON".

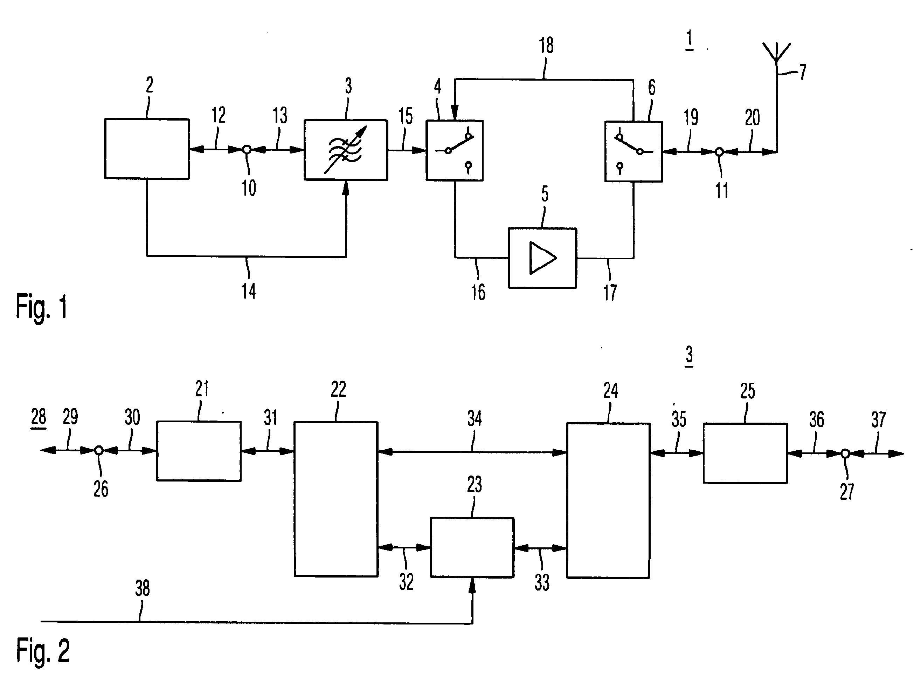

Bevor auf den Aufbau des erfindungsgemäßen schaltbaren Bandpassfilters eingegangen wird, soll anhand Fig. 1 eine geeignete Anwendung für das Filter in einem Kommunikationsgerät 1 gezeigt werden. Ein Transceiver 2 ist über einen schaltbares Bandpassfilter 3 mit einer Antenne 7 verbunden. Dem schaltbare Bandpassfilter 3 wird über ein Digitalsignal 14 die Mittenfrequenz für das zu sendende oder zu empfangende Signal 13, 15 vorgegeben. Das Bandpassfilter 3 ist sowohl im Sendepfad 12, 13, 15, 16, 17, 19, 20 als auch im Empfangspfad 20, 19, 18, 15, 13, 12 des Kommunikationsgerätes enthalten. Im Sendepfad wird zusätzlich über die Schalter 4, 6 (realisierbar beispielsweise über Zirkulatoren 4, 6) ein Leistungsverstärker 5 in den Sendesignalpfad geschaltet. Wird der Transceiver 2 im Frequenzsprungverfahren (engl. frequency hopping) betrieben, so muss die Mittenfrequenz des Bandpassfilters 3, geschaltet über das Digitalsignal 14 vom Transceiver 2, der einzustellenden Sende- oder Empfangsfrequenz ausreichend schnell und mit der hoher Genauigkeit folgen. Zugleich muss das Bandpassfilter 3 für diesen Anwendungsfall eine gute Anpassung an den Ein- und Ausgängen aufweisen. Für die Anpassung sind in einer Ausführungsform des Filters 3 Werte für den Reflexionsfaktor an Eingang S₁₁ und an Ausgang S₂₂ von kleiner -15 dB zu fordern. Das entspricht einem Stehwellenverhältnis (VSWR: Voltage Standing Wave Ratio) kleiner als 1.4. In der genannten Ausführungsform sollte das Bandpassfilter 3 eine möglichst geringe Einfügedämpfung bei großer Linearität der Filterübertragungsfunktion über eine weiten Leistungsbereich aufweisen, da sowohl Sendesignal als auch Empfangssignal über das schaltbare Bandpassfilter 3 übertragen werden. Eine Einfügedämpfung (insertion loss) kleiner als 4 dB ist für ein charakteristisches Ausführungsbeispiel anzustreben. Für mobile Kommunikationsgeräte 2 ist darüber hinaus ein Betrieb innerhalb der spezifizierten Werte für einen weiten Temperaturbereich von -30°C bis +80°C sinnvoll. Diese Forderung muss damit auch von Unterbaugruppen wie dem erfindungsgemäßen schaltbaren Bandpassfilter 3 erfüllt werden.

Wird das schaltbare Bandpassfilter 3 als sog. Cosite-Filter für Frequenzen im UHF-Band (Ultra High Frequency Band) betrieben, so ist in einer Ausführungsform eine Frequenzauflösung von 8 Bit für eine schaltbare Frequenzbandbreite von 225 MHz bis 400 MHz gefordert. Wird das schaltbare Bandpassfilter 3 als Filter für Frequenzen im VHF-Band (Very High Frequency Band) betrieben, so ist in einer Ausführungsform eine Frequenzauflösung von 9 Bit für eine schaltbare Frequenzbandbreite von 30 MHz bis 88 MHz gefordert.

Fig. 2 zeigt den Aufbau einer bevorzugten Ausführung des schaltbaren Bandpassfilters 3 nach vorliegender Erfindung in einem Signalflussplan. Das schaltbare Bandpassfilter 3 ist symmetrisch aufgebaut, d. h. das Bandpassfilter 3 kann mit einem ersten Anschluss 26 als Eingang und einem zweiten Anschluss 27 als Ausgang betrieben werden oder das Bandpassfilter kann mit dem zweiten Anschluss als Eingang und dem ersten Anschluss 26 als Ausgang betrieben werden. Das dargestellte Bandpassfilter 3 zeigt an den Anschlüssen 26, 27 breitbandige Anpassnetzwerke 21, 25 zur Anpassung an den Leitungswellenwiderstand der Signalleitungen 28, 37 auf, typischerweise 50Ω. Das Bandpassfilter 3 weist in dieser Ausführungsform ein erstes Filterelement 22 und ein zweites Filterelement 24 auf. Diese Filterelemente 22; 24 können in Form von Zwei-Kreis-Resonatorfiltern realisiert werden. Die Filterelemente 22, 24 sind einerseits über eine Koppelvorrichtung 23 miteinander gekoppelt. Zusätzlich stehen die beiden Filterelemente 22, 24 andererseits direkt miteinander in elektromagnetischer Wechselwirkung 34. Die Einstellung der Filtermittenfrequenz erfolgt über ein digitales Schaltsignal 38. Die direkte Kopplung 34 des ersten Filterelements 22 und des zweiten Filterelements 24 zusätzlich zu der Kopplung 32,33 über ein Koppelelement 23 führt zu einer geringen Baugröße des erfindungsgemäßen schaltbaren Bandpassfilters 3, da auf eine raum- und zugleich kostentreibende Schirmung zwischen erstem Filterelement 22 und zweitem Filterelement 24 auf Grund der gezielten Kopplung verzichtet werden kann.

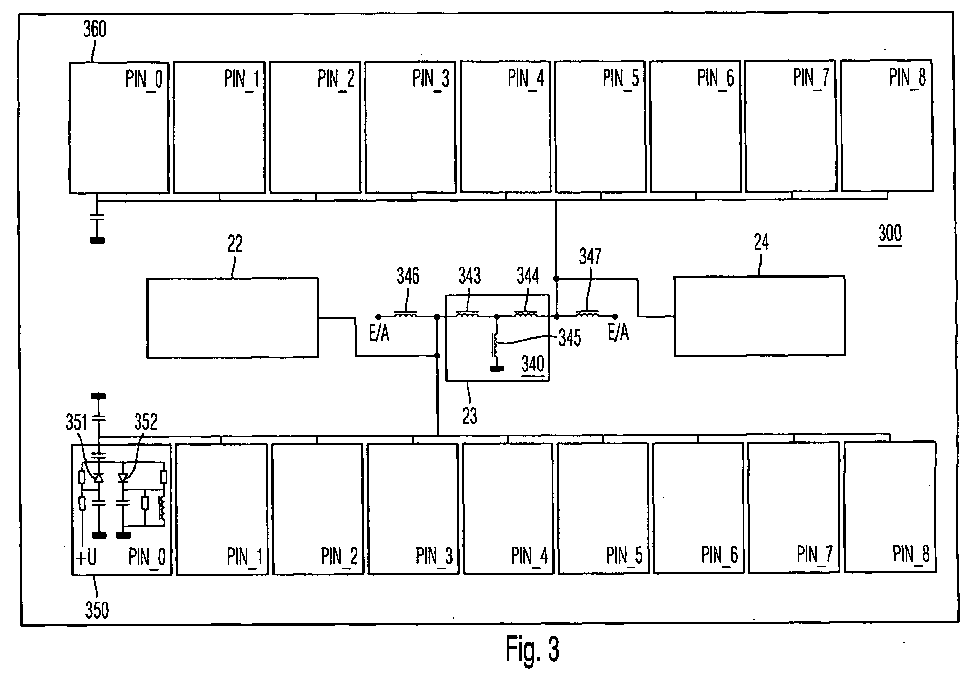

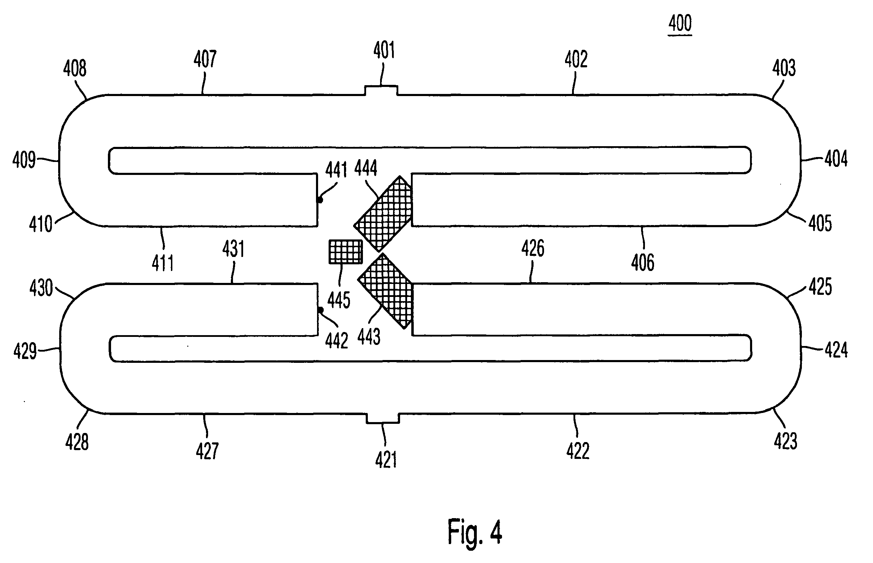

Anhand von Fig. 3 und Fig. 4 wird nun ein Ausführungsbeispiel des schaltbaren Bandpassfilters 3 für Frequenzen im VHF-Bereich von 30 MHz bis 88 MHz und eine Frequenzauflösung von etwa 116 kHz bei 9 bit dargestellt. Das erste Filterelement 22 und das zweite Filterelement 24 sind als TEM-Resonatoren (Transversal-Elektro-Magnetische Welle) in Mikrostreifenleitungstechnik realisiert. Das erste Filterelement 22 umfasst vier gekoppelten Mikrostreifenleitungsabschnitte 402, 406, 407, 411. Das zweite Filterelement umfasst in gleicher Weise vier weitere gekoppelte Mikrostreifenleitungsabschnitte 422, 426, 427, 431. Erstes Filterelement 22 und zweites Filterelement 24 sind symmetrisch zueinander angeordnet und liegen in derselben Ebene, d. h. auf derselben Flächen einer Leiterplatte. Die Kopplung zwischen dem ersten Filterelement 22 und dem zweiten Filterelement 24 wird zusätzlich zur vorhandenen direkten Kopplung über eine Kopplungsvorrichtung in Form eines T-Glieds mit den Induktivitäten 443, 444, 445 als induktive Stromkopplung genau eingestellt. Jeweils im Hochpunkt der beiden Resonatoren als dem ersten bzw. dem zweiten Filterelement 22, 24 wird das frequenzabstimmende Kondensatornetzwerk der Koppelvorrichtung 23 mittels PIN-Dioden zugeschaltet.

Fig. 3 erläutert den Aufbau des die schaltbare Mittenfrequenz des Bandpassfilters 3 frequenzbestimmenden Kondensatornetzwerks 300 geschaltet über PIN-Dioden. Das Kondensatornetzwerk 300 ist für das erste Filterelement 22 und das zweite Filterelement 24 symmetrisch aufgebaut. Die mit E/A gekennzeichneten Ein- bzw. Ausgänge des Bandpassfilters sind über Anpasselemente 346 bzw. 347 mit der Koppelvorrichtung 23 verbunden. Die Anpasselemente 346, 347 können wie dargestellt eine Spule oder aber beliebige alternative Reaktanzschaltungen umfassen. Je nach Wert des digitalen Schaltsignals 38 werden dem ersten Filterelement 22 und dem zweiten Filterelement 24 das Kondensatornetzwerk symmetrisch teilweise zugeschaltet. Darüber hinaus weist die Koppelvorrichtung ein T-Glied 340 aus Induktivitäten 343, 344, 345 zur genauen Einstellung der Kopplung als induktive Stromkopplung des ersten Filterelements 22 und des zweiten Filterelements 24 auf. Ein Schaltnetzwerk 350 zur Zuschaltung von Kapazitäten ist für die PIN-Dioden 351, 352 ausgeführt. Weist das Digitalsignal 38 den Wert PIN_0 = "ON" auf, so wird über dieses Schaltnetzwerk 350 dem ersten Filterelement 22 eine zusätzliche Kapazität ebenso wie symmetrisch dazu durch das Schaltnetzwerk 360 eine Kapazität dem zweiten Filterelement 24 zugegeschaltet. Die Mittenfrequenz des schaltbaren schmalbandigen Bandpassfilters 3 wird durch das Zuschalten von Kapazitäten durch die Schaltnetzwerke 350,360 verändert. Zusätzlich und in Fig. 3 nicht dargestellt sind für Ansteuerung der PIN-Dioden des geschilderten Ausführungsbeispiels geeignete Ansteuerschaltungen vorzusehen, die jedoch für sich bekannt sind und auf deren genaue Erläuterung daher hier verzichtet wird.

Fig. 4 zeigt den Aufbau und die erfindungsgemäße Anordnung der Resonatoren des schaltbaren VHF-Bandpassfilters 3. Der erste Resonator als erstes Filterelement 22 umfasst einen ersten Mikrostreifenleitungsabschnitt 402 und einen zweiten Mikrostreifenleitungsabschnitt 407, die in einer Linie liegen und in ihrem Verbindungspunkt 401, an dem der erste und der zweite Mikrostreifenleitungsabschnitt 402, 407 ineinander übergehen, befindet sich ein erster Anschluss des schaltbaren Bandpassfilters 3. An dem dem Verbindungspunkt 401 gegenüberliegendem Ende der Mikrostreifenleitungsabschnitte 402, 407 schließt sich jeweils ein erster bzw. ein zweiter Viertelkreisbogen 403 bzw. 408 an, gefolgt von einem kurzen geraden Leitungsstück 404 bzw. 409. Mittels der geraden Leitungsstücke 404, 409 wird der Abstand zwischen den parallel zueinander verlaufenden Mikrostreifenleitungsabschnitten 402/406, 407/411 eingestellt. Daran anschließend folgt jeweils ein dritter bzw. ein vierter Viertelkreisbogen 405 bzw. 410. Dieser dritte bzw. vierte Viertelkreisbogen 405, 410 wird jeweils von dem dritten und vierten Mikrostreifenleitungsabschnitt 406 und 411 gefolgt, wobei der vierte Mikrostreifenleitungsabschnitt 411 an ihrem von dem vierten Viertelkreisbogen 410 abgewandten Ende über eine Durchkontaktierung 441 mit Masse verbunden ist. Der dritte Mikrostreifenleitungsabschnitt 406 und der vierte Mikrostreifenleitungsabschnitt 411 liegen im geschilderten Ausführungsbeispiel auf einer gemeinsamen Geraden.

Das zweite Filterelement 24 ist zu dem ersten Filterelement symmetrisch aufgebaut. Das zweite Filterelement 24 umfasst einen fünften Mikrostreifenleitungsabschnitt 422 und einen sechsten Mikrostreifenleitungsabschnitt 427, die aufeinanderfolgend in einer Linie liegen. In ihrem Verbindungspunkt 421 befindet sich ein zweiter Anschluss des schaltbaren Bandpassfilters 3. An ihrem dem Verbindungspunkt 421 gegenüberliegenden Ende schließt sich jeweils ein fünfter bzw. ein sechster Viertelkreisbogen 423 bzw. 428 an, gefolgt von einem kurzen geraden Leitungsstück 424 bzw. 429. Wie schon beim ersten Filterelement 22 legen die geraden Leitungsstücke 424, 429 den Abstand der parallelen Mikrostreifenleitungsabschnitte 422/426 und 427/431 fest. Daran anschließend folgt jeweils ein siebter bzw. ein achter Viertelkreisbogen 425 bzw. 430. Dieser siebte bzw. achte Viertelkreisbogen 425, 430 wird jeweils von einem siebten und einem achten Mikrostreifenleitungsabschnitt 426 und 431 gefolgt, wobei der achte Mikrostreifenleitungsabschnitt 431 an ihrem von dem anderen Viertelkreisbogen abgewandten Ende über eine Durchkontaktierung 442 mit Masse verbunden ist. Der siebte Mikrostreifenleitungsabschnitt 426 und der achte Mikrostreifenleitungsabschnitt 431 liegen im geschilderten Ausführungsbeispiel auf einer gemeinsamen Geraden. Dabei sind die beiden Filterelemente 22, 24 so angeordnet, dass die jeweils auf einer Geraden liegenden Mikrostreifenleitungsabschnitte 406, 411 einerseits und 426, 431 andererseits parallel zueinander und benachbart angeordnet sind. Damit wird eine unmittelbare elektromagnetische Kopplung zwischen erstem und zweitem Filterelement 22, 24 über die Mikrostreifenleitungen 406, 411, 426, 431 erreicht. Die Mikrostreifenleitungsabschnitte 406 und 426 bzw. 411 und 431 sind unmittelbar benachbart, d. h. über ihre vollständige jeweilige Längenerstreckung befinden sich keine Elemente zwischen den Mikrostreifenleitungsabschnitten, insbesondere keine Schirmung. Die Kopplung zwischen erstem Filterelement 22 und zweitem Filterelement 24 wird darüber hinaus über ein T-Glied mit den Induktivitäten 443, 444, 445 als induktive Stromkopplung genau eingestellt. Dieses T-Glied ist zwischen dem dritten Mikrostreifenleitungsabschnitt 406 des ersten Filterelements 22 und dem dritten Mikrostreifenleitungsabschnitt 426 des zweiten Filterelements 24 angeordnet.

Die Anordnung der Mikrostreifenleitungsabschnitte 406, 411 einerseits und 426, 431 andererseits parallel zueinander und unmittelbar benachbart zu einer direkten elektromagnetischen Kopplung ermöglicht eine entsprechende bauraumoptimierte Bauform des erfindungsgemäßen schaltbaren Bandpassfilters 3. Auf eine Schirmung zwischen den benachbarten Mikrostreifenleitungen der Filterelemente 22, 24 wird explizit verzichtet. Zusätzlich ermöglicht der Aufbau des schaltbaren Bandpassfilters 3 für den VHF-Bereich in dem dargestellten Ausführungsbeispiel eine große mechanische Stabilität infolge des Aufbaus in Mikrostreifenleitungstechnik verglichen mit einer Realisierung der Resonatoren für das erste und das zweite Filterelement 22, 24 in Form von Luftspulen. Die Symmetrie des Aufbaus stellt eine wesentliche Vereinfachung des Abgleichs der beiden Filterelemente sicher. Auf der Leiterplatte für das Bandpassfilter werden die Mikrostreifenleitungen für die Resonatorstruktur der beiden Filterelemente 22, 24 auf einer Seite (B-Seite) und das Koppelelement 23 mit dem Kondesator-/PIN-Dioden-Netzwerk auf der anderen Seite (L-Seite) aufgebracht. Als Substrat für die Leiterplatte kann eine mehrlagige Platine (Hersteller beispielsweise Rogers, 10-lagig, εᵣ=3.66) verwendet werden. Die Bauteile des Kondensator-/PIN-Dioden-Netzwerks sind automatisch bestückbar (SMD-Technik, surface mounted device) und im Wiederaufschmelzverfahren lötbar. Fertigung und Abgleich des erfindungsgemäßen Bandpassfilters 3 sind damit auf eine besonders effiziente und kostengünstige Fertigung ausgelegt. Das Gesamtvolumen für diese Ausführung des erfindungsgemäßen Bandpassfilters für den VHF-Bereich kann damit einschließlich Gehäuse auf weniger als 13 cm × 7 cm × 3 cm beschränkt werden. Damit ist das dargestellte schaltbare VHF-Bandpassfilter 3 einfach in vorhandene Gerätekonzepte zu integrieren. Ermöglicht wird dies durch die gewählte Gestaltung der Filterelemente 22, 24 und die erfindungsgemäße direkte elektromagnetische Kopplung der Filterelemente 22, 24.

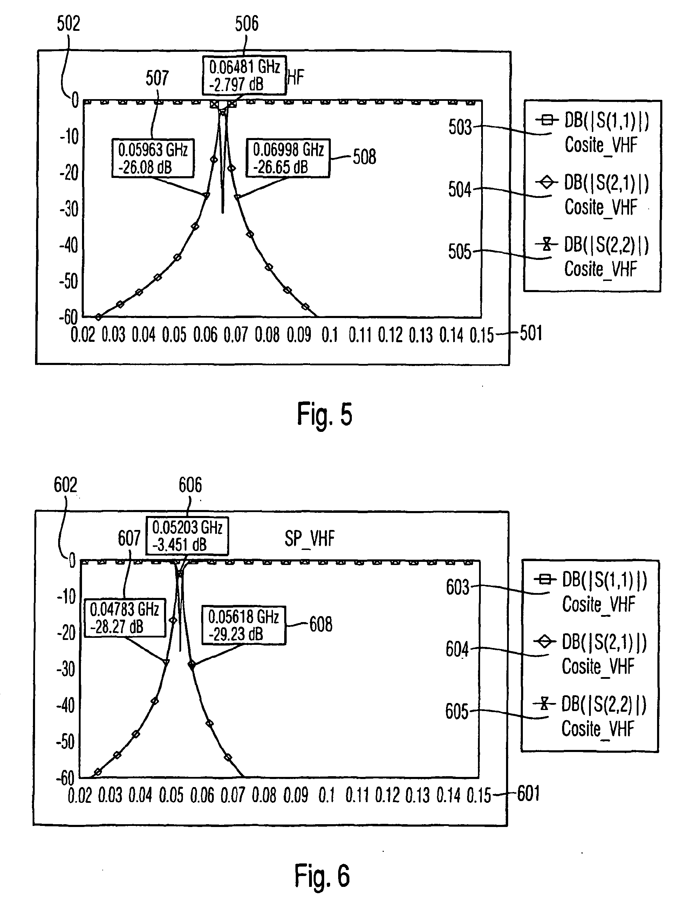

Fig. 5 zeigt eine Simulation der Streuparameter (abgekürzt S-Parameter) des schaltbaren VHF-Bandpassfilters 3 nach Fig. 3 und Fig. 4 für ein digitales Schaltsignal 38 mit den Einstellungen PIN_0, PIN_1, PIN_2, PIN_3, PIN_4, PIN_5 auf "ON". Auf der horizontalen Achse 501 ist die Frequenz in Gigahertz aufgetragen. Auf der vertikalen Achse 502 sind die Beträge der Streuparameter in dB aufgetragen. Die Kurve 503 stellt die eingangsseitige Anpassung des schaltbaren Bandpassfilters 3 in Form des Betrags des Eingangsreflexionsfaktors |S₁₁| dar. Die Kurve 505 stellt die ausgangsseitige Anpassung des schaltbaren Bandpassfilters 3 in Form des Betrags des Ausgangsreflexionsfaktors |S₂₂| dar. Das schaltbare Bandpassfilter 3 ist für eine Mittenfrequenz f_{ctr} von 0.0641 GHz angepasst mit Werten für |S₁₁| und |S₂₂| kleiner -30 dB. Die Selektivität des schaltbaren Bandpassfilters 3 wird für die gezeigte Mittenfrequenz f_{ctr} und für Frequenzen, die von f_{ctr} um 8% abweichen gezeigt. Für eine Frequenz von f_{ctr}= 0.06481 GHZ lautet der Betrag der Filterübertragungsfunktion 506 und damit die Einfügedämpfung |S₂₁|= -2.797 dB. Die Dämpfung des Bandpassfilters 3 beträgt für eine Frequenz von 0,05963 GHz -26.06 dB 507 und für eine Frequenz von 0.06996 Ghz -26.65 dB 508.

Fig. 6 zeigt eine Simulation der Streuparameter (abgekürzt S-Parameter) des schaltbaren VHF-Bandpassfilters 3 nach Fig. 3 und Fig. 4 für ein digitales Schaltsignal 38 mit einer gegenüber Fig. 5 geänderten Einstellungen der PIN-Dioden. Auf der horizontalen Achse 601 ist die Frequenz in GHz aufgetragen. Auf der vertikalen Achse 602 sind die Werte des Streuparameters in dB aufgetragen. Die Kurve 603 stellt die eingangsseitige Anpassung des schaltbaren Bandpassfilters 3 in Form des Betrags des Eingangsreflexionsfaktors |S₁₁| dar. Die Kurve 605 stellt die ausgangsseitige Anpassung des schaltbaren Bandpassfilters 3 in Form des Betrags des Ausgangsreflexionsfaktors |S₂₂| dar. Das schaltbare Bandpassfilter 3 ist für eine Mittenfrequenz f_{ctr} von 0.05203 GHz angepasst mit Werten für |S₁₁| und |S₂₂| kleiner -20 dB. Die Selektivität des schaltbaren Bandpassfilters 3 wird für die gezeigte Mittenfrequenz f_{ctr} und für Frequenzen, die von f_{ctr} um 8% abweichen gezeigt. Für eine Frequenz von f_{ctr}= 0.05203 GHZ lautet der Betrag der Filterübertragungsfunktion 606 und damit die Einfügedämpfung |S₂₁|= -3.451 dB. Die Dämpfung des Bandpassfilters 3 beträgt für eine Frequenz von 0,04783 GHz -28.27 dB (Anzeige 607) und für eine Frequenz von 0.05618 Ghz -29.23 dB (Anzeige 608).

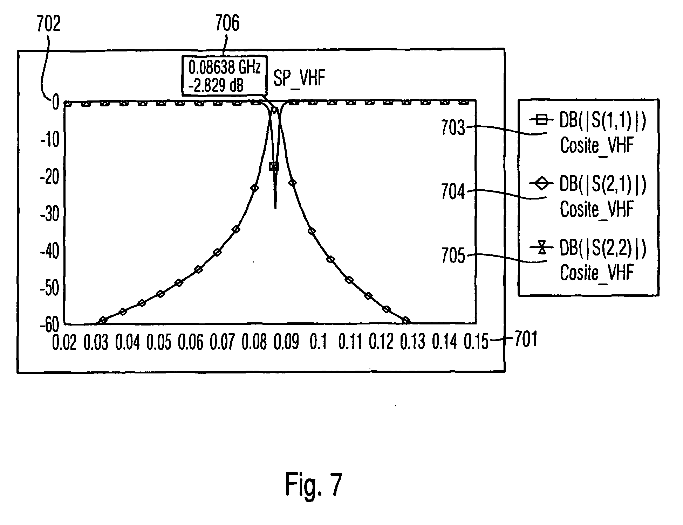

Fig. 7 zeigt eine Simulation der Streuparameter (abgekürzt S-Parameter) des schaltbaren VHF-Bandpassfilters 3 nach Fig. 3 und Fig. 4 für ein digitales Schaltsignal 38 mit den Einstellungen PIN_0, PIN_1 auf ON. Auf der horizontalen Achse 701 ist die Frequenz in GHz aufgetragen. Auf der vertikalen Achse 702 sind die Beträge der Streuparameter S₁₁, S₂₂ und S₂₁ in dB aufgetragen. Die Kurve 703 stellt die eingangsseitige Anpassung des schaltbaren Bandpassfilters 3 in Form des Betrags des Eingangsreflexionsfaktors |S₁₁| dar. Die Kurve 705 stellt die ausgangsseitige Anpassung des schaltbaren Bandpassfilters 3 in Form des Betrags des Ausgangsreflexionsfaktors |S₂₂| dar. Das schaltbare Bandpassfilter 3 ist für eine Mittenfrequenz f_{ctr} von 0.08638 GHz angepasst mit Werten für |S₁₁| und |S₂₂| kleiner -25 dB. Die Selektivität des schaltbaren Bandpassfilters 3 wird für die gezeigte Mittenfrequenz f_{ctr} mit der Anzeige 706 gezeigt. Für eine Frequenz von f_{ctr}= 0.06481 GHZ lautet der Betrag der Filterübertragungsfunktion 704, 706 und damit die Einfügedämpfung |S₂₁|= -2.829 dB.

Fig. 5, Fig. 6 und Fig. 7 zeigen in einem Ausführungsbeispiel für Frequenzen im VHF-Bereich anhand simulierter S-Parameter ein schmalbandiges, über einen weiten Frequenzbereich schaltbares Bandpassfilter 3 mit hoher Selektivität und geringer Einfügedämpfung. In einem weiteren Ausführungsbeispiel wird ein erfindungsgemäßes Bandpassfilter 3 für den UHF-Bereich vorgestellt.

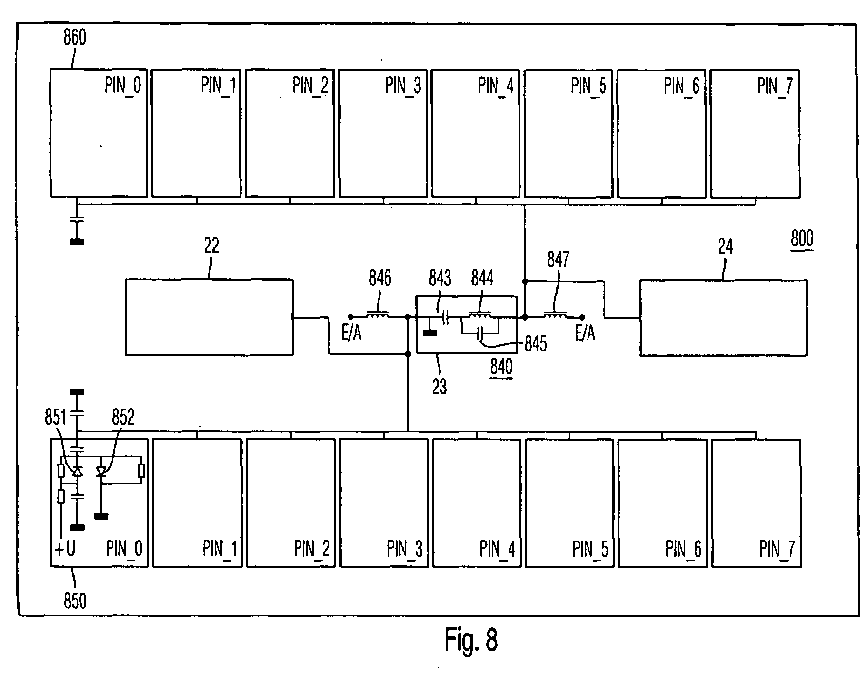

Fig. 8 erläutert den Aufbau des die schaltbare Mittenfrequenz des UHF-Bandpassfilters 3 frequenzbestimmende Kondensatornetzwerk 800 als Koppelvorrichtung 23, geschaltet über PIN-Dioden. Das Kondensatornetzwerk 800 ist für erstes Filterelement 22 und zweites Filterelement 24 symmetrisch aufgebaut. Die mit E/A gekennzeichneten Ein- bzw. Ausgänge des Bandpassfilters sind über Anpasselemente 846 bzw. 847 mit der Koppelvorrichtung 23 verbunden. Die Anpasselemente 846, 847 können wie dargestellt eine Spule oder aber beliebige alternative Reaktanzschaltungen umfassen. Je nach Wert des digitalen Schaltsignals 38 werden erstem Filterelement 22 und zweitem Filterelement 24 Teile des Kondensatornetzwerks symmetrisch teilweise zugeschaltet. Darüber hinaus weist die Koppelvorrichtung 23 ein Koppelelement 840 aus Induktivitäten und Kapazitäten zur genauen Einstellung der Kopplung des ersten Filterelements 22 und des zweiten Filterelements 24 auf. Ein Schaltnetzwerk 850 zur Zuschaltung von Kapazitäten ist mit den PIN-Dioden 851, 852 ausgeführt. Weist das Digitalsignal 38 den Wert PIN_0= "ON" auf, so wird über dieses Schaltnetzwerk 850 dem ersten Filterelement 22 eine zusätzliche Kapazität ebenso wie symmetrisch dazu durch das Schaltnetzwerk 860 eine Kapazität dem zweiten Filterelement 24 zugegeschaltet. Die Mittenfrequenz des schaltbaren schmalbandigen Bandpassfilters 3 wird durch das Zuschalten der Kapazitäten durch die Schaltnetze 850,860 verändert. Die erfindungsgemäße Verwendung von PIN-Dioden als Schaltelement ermöglicht die Übertragung größerer Leistungen über das schaltbare Bandpassfilter 3 als es die Verwendung von Varaktordioden ermöglichen würde. Damit ist die Verwendung des Bandpassfilters 3 als Cosite-Filter möglich.

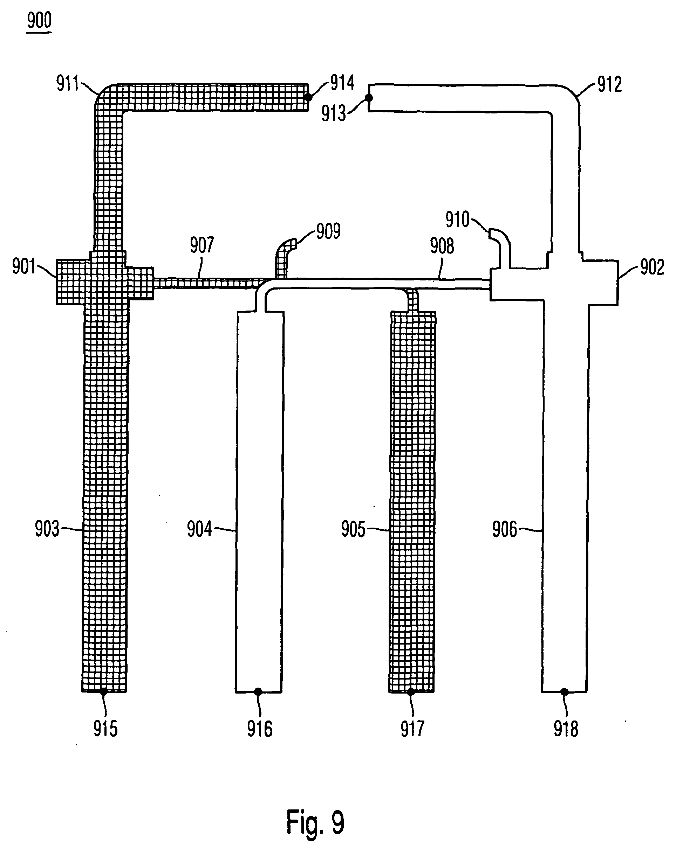

Fig. 9 zeigt den Aufbau des Bandpasses für eine Ausführung des erfindungsgemäßen Bandpasses für Frequenzen im UHF-Bereich. Die Frequenzauflösung des schaltbaren Bandpassfilters 3 beträgt in diesem Fall 8 bit, so dass eine Schrittweite für die Mittenfrequenz von 700 kHz erreichbar ist. Der gesamte Abstimmbereich des schaltbaren Bandpassfilters im UHF-Band im vorliegenden zweiten Ausführungsbeispiel reicht von 225 MHz bis 400 MHz.

In Fig. 9 besteht das erste Filterelement 22 aus zwei parallelen geraden Mikrostreifenleitungsasbschnitten 903,905, die über einen Leitungsabschnitt 907 miteinander verbunden sind. Die Mikrostreifenleitungabschnitte 903, 905 sind an ihrem Ende jeweils über eine Durchkontaktierung 915, 917 mit Masse verbunden. An dem der Durchkontaktierung 915, 917 gegenüberliegendem Ende sind die die Mikrostreifenleitungsabschnitte über den zu den Leitungen 903, 905 rechtwinkligen geraden Leiterabschnitt 907 miteinander und mit dem ersten Anschluss 901 verbunden. Zusätzlich weist das erste Filterelement 22 einen L-förmigen Mikrostreifenleitungsabschnitt 911 auf, der mit dem ersten Anschluss 901 des Bandpassfilters 3 verbunden ist. Dieser L-förmige Mikrostreifenleitungsabschnitt 911 ist in der vorliegenden Ausführung in Verlängerung des Mikrostreifenleitungsabschnitts 903 angeordnet und im vorliegenden Fall nach einer bestimmten Länge um 90° zur L-Form abgewinkelt. Dieser Mikrostreifenleitungsabschnitt 911 dient dem Abgleich des ersten Filterelements 22. Zusätzlich wird über einen Leitungsabschnitt 909, der rechtwinklig von der Verbindungsleitung 907 der beiden Mikrostreifenleitungsabschnitten abzweigt, die Koppelvorrichtung 23 bestehend aus einem Koppelnetzwerk 23 aus PIN-Dioden und Kapazitäten mit dem Filterelement 22 verbunden. Das zweite Filterelement 24 des Bandpasses 24 ist vergleichbar dem erstem Filterelement 22 aufgebaut. Das zweite Filterelement 24 besteht ebenso aus zwei parallelen, geradlinigen Mikrostreifenleitungsabschnitten 904, 906, die jeweils an einem Ende 916, 918 kurzgeschlossen und an dem gegenüberliegenden Ende über eine rechtwinklig zu den Mikrostreifenleitungen 904, 906 ausgebildete Verbindlungsleitung 908 verbunden sind. Das zweite Filterelement 24 weist weiter einen L-förmigen Mikrostreifenleitungsabschnitt 912 auf, der mit dem Ausgang 902 des Bandpassfilters 3 verbunden ist. Dieser Mikrostreifenleitungsabschnitt 912 ist in der vorliegenden Ausführung in Verlängerung des ersten Mikrostreifenleitungsabschnitts 915 des zweiten Filterelements 24 angeordnet und im vorliegenden Fall ebenfalls nach einer bestimmten Länge um 90° abgewinkelt. Dieser Mikrostreifenleitungsabschnitt 912 dient dem Abgleich des zweiten Filterelements 24. Zusätzlich wird über einen Leitungsabschnitt 910, der rechtwinklig von der Verbindungsleitung 908 der beiden Mikrostreifenleitungen 904, 906 abzweigt, die Koppelvorrichtung 23 bestehend aus einem Koppelnetzwerk 23 aus PIN-Dioden und Kapazitäten mit dem zweiten Filterelement 24 verbunden. Die Filterelemente 22, 24 sind mit allen zueinander parallel liegenden Mikrostreifenleitungsabschnitten 903, 905, 904, 906 auf verschiedenen Lagen einer mehrlagigen Leiterplatte so angeordnet, dass die kurzgeschlossenen Enden 915, 916, 917, 918 in die dieselbe Richtung weisen und auf einer Geraden senkrecht zu den Mikrostreifenleitungsabschnitten 903, 904, 905, 906 liegen und die Mikrostreifenleitungsabschnitte 903, 905 und 904, 906 des ersten bzw. des zweiten Filterelements 22, 24 zugleich abwechselnd aufeinander folgen. Die geschilderte Anordnung gewährleistet zugleich gute Symmetrie des schaltbaren Bandpassfilters 3 bezüglich der Anschlüsse 901, 902 und gute unmittelbare elektromagnetische Kopplung zwischen erstem Filterelement 22 und zweitem Filterelement 24 bei gleichzeitig minimalem Raumbedarf der Anordnung. Das erfindungsgemäße schaltbare Bandpassfilter 3 erreicht so eine geringe Baugröße von ca. 45 mm × 40 mm für den in Fig. 9 dargestellten Anteil des Bandpassfilters 3 umfassend die Filterelemente 22, 24. Die Anordnung der Elemente auf unterschiedlichen Ebenen einer mehrlagigen Leiterplatte ist durch die unterschiedliche Schraffur dargestellt. Es würde allerdings auch genügen, lediglich die überlappenden Verbindungsleitungen 907, 908 auf unterschiedlichen Ebenen vorzusehen. Ober das Gehäuse der gesamten Baugruppe des schaltbaren Bandpassfilters 3 einschließlich des Kondensator-/PIN-Diodennetzwerks 23 sind Abmessungen von weniger als 6.6 cm × 6 cm × 3 cm erreichbar. Damit ist das zweite Ausführungsbeispiel des schaltbaren UHF-Bandpassfilters 3 einfach in vorhandene Gerätekonzepte, insbesondere für mobile Kommunikationsgeräte mit geringen Gesamtabmessungen zu integrieren. Ermöglicht wird dies durch die erfindungsgemäße Ausbildung der Filterelemente 22 und 24 und die erfindungsgemäße Kopplung der Filterelemente 22, 24. Optimale Symmetrie des schaltbaren Bandpassfilters 3 wird dadurch erreicht, dass die mittels PIN-Dioden frequenzbestimmende Koppelvorrichtung 23 jeweils im Hochpunkt der Resonatoren, die das erste Filterelement 22 und das zweite Filterelement 24 bilden, erfolgt. Der gedruckte Aufbau der Resonatoren des ersten Filterelements 22 und des zweiten Filterelements 24 gewährleistet eine hohe mechanische Stabilität des Bandpassfilters 3, das dadurch robust gegen Erschütterungen ausgelegt ist. Zusätzliche diskrete Kapazitäten C und Induktivitäten L in SMD-Bauform können zur Veränderung der Kopplung der Filterelemente 22, 24 zum Einsatz gelangen. Die gesamte Baugruppe kann auf einer mehrlagigen Leiterplatte (Hersteller: z. B. Rogers, 10-lagig) als Substrat aufgebaut werden. Die dargestellte Auslegung des erfindungsgemäßen Bandpassfilters 3 ermöglicht die effiziente Fertigung mittels Verfahren für automatische Bestückung für SMD-Technologie und den Einsatz des Wiederaufschmelzlötverfahrens.

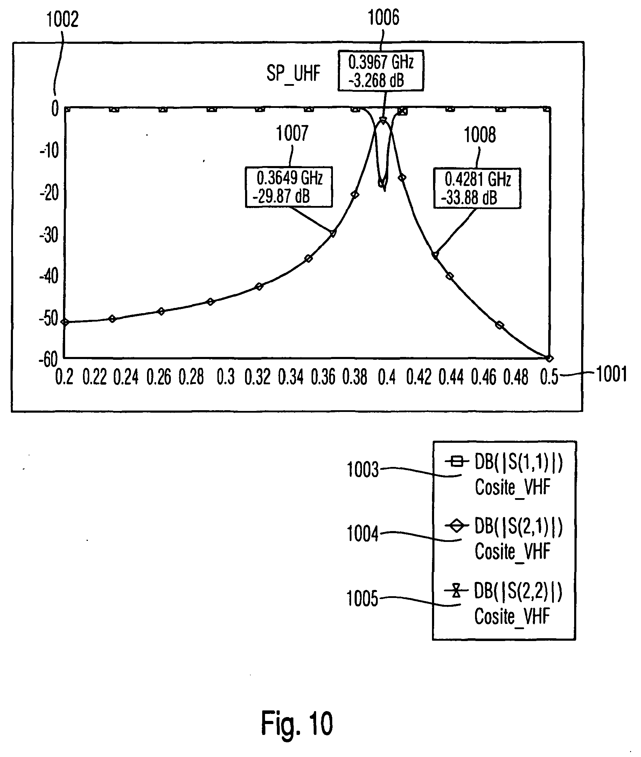

Fig. 10 zeigt eine Simulation der Streuparameter (abgekürzt S-Parameter) des schaltbaren UHF-Bandpassfilters 3 nach Fig. 8 und Fig. 9 für ein digitales Schaltsignal 38 mit den Einstellungen PIN_0, PIN_1, PIN_2, auf "ON". Auf der horizontalen Achse 1001 ist die Frequenz in Gigahertz (abgekürzt GHz) aufgetragen. Auf der vertikalen Achse 1002 sind die Werte des Betrags der Streuparameter in dB aufgetragen. Die Kurve 1003 stellt die eingangsseitige Anpassung des schaltbaren Bandpassfilters 3 in form des Betrags des Eingangsreflexionsfaktors |S₁₁| dar. Die Kurve 1005 stellt die ausgangsseitige Anpassung des schaltbaren Bandpassfilters 3 in Form des Betrags des Ausgangsreflexionsfaktors |S₂₂| dar. Das schaltbare Bandpassfilter 3 ist für eine Mittenfrequenz f_{ctr} von 0.3967 GHz angepasst mit Werten für |S₁₁| und |S₂₂| kleiner -15 dB. Die Selektivität des schaltbaren Bandpassfilters 3 wird für die gezeigte Mittenfrequenz f_{ctr} und für Frequenzen, die von f_{ctr} abweichen, gezeigt. Für eine Frequenz von f_{ctr}= 0.3967 GHz lautet der Betrag der Filterübertragungsfunktion 1006 und damit die Einfügedämpfung |S₂₁|= -3.266 dB. Die Dämpfung des Bandpassfilters 3 beträgt für eine Frequenz von 0,3694 GHz -29.87 dB 1007 und für eine Frequenz von 0.4281 Ghz -33.88 dB 1008.

Das erfindungsgemäße schaltbare Bandpassfilter ist nicht auf die geschilderten Ausführungsformen beschränkt, sondern kann auch in vorteilhafter Weise entsprechend den Eigenschaften des Anspruchs 1 realisiert werden. Dabei sind alle dargelegten Merkmale der Erfindung in geeigneter Form miteinander kombinierbar.

## Patentansprüche

1. Schaltbares Bandpassfilter (3), umfassend ein erstes Filterelement (22), ein zweites Filterelement (24), die über eine schaltbare Koppelvorrichtung (23) miteinander gekoppelt sind,
**dadurch gekennzeichnet,**
**dass** das erste und das zweite Filterelement (22, 24) jeweils eine in einer Ebene flächig ausgebildete Leiterstruktur aufweisen, die jeweils mindestens zwei Leitungsabschnitte umfasst, wobei das erste und das zweite Filterelement (22, 24) in mindestens einem jeweils geradlinig verlaufenden Abschnitt der Leitungsabschnitte (406/426, 411/413, 903-906) in direkter elektromagnetischer Wechselwirkung miteinander stehen.

2. Schaltbares Bandpassfilter (3) nach Anspruch 1,
**dadurch gekennzeichnet,**
**dass** das erste und das zweite Filterelement (22, 24) aus an jeweils einem am Ende mit Masse verbundenen Mikrostreifenleitungen bestehen.

3. Ein schaltbares Bandpassfilter (3) nach Anspruch 1 oder 2,
**dadurch gekennzeichnet,**
**dass** die Koppelvorrichtung (23) aus einem Netzwerk gebildet aus Halbleiterdioden und Kondensatoren und/oder Induktivitäten besteht.

4. Schaltbares Bandpassfilter (3) nach einem der Ansprüche 1 bis 3,
**dadurch gekennzeichnet,**
**dass** die Koppelvorrichtung (23) Varaktordioden oder Pindioden enthält.

5. Schaltbares Bandpassfilter (3) nach einem der Ansprüche 1 bis 4,
**dadurch gekennzeichnet,**
**dass** das Bandpassfilter (3) auf einer oder mehreren mehrlagigen Leiterplatten aufgebaut ist, und
wobei auf einer oder mehreren Lagen der Leiterplatte das erste und das zweite Filterelement (22, 24) ausgebildet sind und auf einer oder weiteren Lagen die Koppelvorrichtung (23) und Ansteuerschaltungen ausgebildet sind.

6. Schaltbares Bandpassfilter (3) nach einem der Ansprüche 1 bis 5,
**dadurch gekennzeichnet,**
**dass** ein erster und ein zweiter Anschluss (26, 27) des Bandpassfilters (3) jeweils an einem Abschnitt des ersten Filterelements (22) und des zweiten Filterelements (24) ausgebildet sind.

7. Ein schaltbares Bandpassfilter (3) nach einem der Ansprüche 1 bis 6,
**dadurch gekennzeichnet,**
**dass** die Koppelvorrichtung (23) so ausgebildet ist, dass die dem ersten und dem zweiten Filterelement (22, 24) zuschaltbaren Kondensatoren für das erste und das zweite Filterelement (22, 24) jeweils gleich groß sind.

8. Schaltbares Bandpassfilter (3) nach einem der Ansprüche 1 bis 7,
**dadurch gekennzeichnet,**
**dass** das erste und das zweite Filterelement (22, 24) zueinander symmetrisch aufgebaut sind.

9. Schaltbares Bandpassfilter (3) nach einem der Ansprüche 1 bis 8,
**dadurch gekennzeichnet,**
**dass** das Bandpassfilter (3) bezüglich des ersten und zweiten Anschlusses (26, 27) symmetrisches Verhalten zeigt.

10. Schaltbares Bandpassfilter (3) nach einem der Ansprüche 1 bis 9,
**dadurch gekennzeichnet,**
**dass** Leitungsabschnitte des ersten und des zweiten Filterelements (22, 24) so umgebogen sind, dass in jedem Filterelement je vier, paarweise zueinander parallele Mikrostreifenleitungsabschnitte entstehen (402, 406, 407, 411, 422, 426, 427, 431) .

11. Schaltbares Bandpassfilter (3) nach einem der Ansprüche 1 bis 10,
**dadurch gekennzeichnet,**
**dass** die Leitungsabschnitte (903 - 906) des ersten und des zweiten Filterelements (22, 24) abwechselnd parallel zueinander angeordnet sind und jeweils die Leitungsabschnitte (903, 905; 904, 906) an einem Ende elektrisch leitend verbunden sind.

12. Schaltbares Bandpassfilter (3) nach Anspruch 11,
**dadurch gekennzeichnet,**
**dass** das erste und das zweite Filterelement (22, 24) jeweils einen weiteren Leitungsabschnitt (911, 912) geeignet zur Abstimmung der Filterfrequenz aufweisen.

13. Schaltbares Bandpassfilter (3) nach einem der Ansprüche 12 bis 13,
**dadurch gekennzeichnet,**
**dass** das erste und das zweite Filterelement (22, 24) auf unterschiedlichen Lagen der Leiterplatte angeordnet sind.

## Claims

1. Switchable bandpass filter (3), comprising a first filter element (22) and a second filter element (24) which are coupled with one another by means of a switchable coupling device (23),
**characterised in that**
the first and the second filter elements (22, 24) each exhibit a conductor structure which is embodied in flat form in one plane and in each case comprises at least two line sections, wherein the first and the second filter elements (22, 24) are in direct electromagnetic interaction with one another in at least one in each case straight line section of the line sections (406/426, 411/413, 903-906).

2. Switchable bandpass filter (3) according to claim 1,
**characterised in that**
the first and the second filter elements (22, 24) consist of microstrip lines each connected with ground at the end.

3. Switchable bandpass filter (3) according to claim 1 or 2,
**characterised in that** the coupling device (23) consists of a network formed of semiconductor diodes and capacitors and/or inductors.

4. Switchable bandpass filter (3) according to one of claims 1 to 3,
**characterised in that** the coupling device (23) comprises varactor diodes or pin diodes.

5. Switchable bandpass filter (3) according to one of claims 1 to 4,
**characterised in that** the bandpass filter (3) is constructed on one or more multilayer printed circuit boards, and
wherein the first and the second filter elements (22, 24) are formed on one or more layers of the printed circuit board and the coupling device (23) and actuating circuits are formed on one or further layers.

6. Switchable bandpass filter (3) according to one of claims 1 to 5,
**characterised in that** a first and a second connection (26, 27) of the bandpass filter (3) are in each case formed in a section of the first filter element (22) and the second filter element (24).

7. Switchable bandpass filter (3) according to one of claims 1 to 6,
**characterised in that** the coupling device (23) is formed so that the capacitors for the first and the second filter elements (22, 24) which can be switched to the first and the second filter elements (22, 24) are in each case the same size.

8. Switchable bandpass filter (3) according to one of claims 1 to 7,
**characterised in that** the first and the second filter elements (22, 24) are constructed symmetrically to one another.

9. Switchable bandpass filter (3) according to one of claims 1 to 8,
**characterised in that** the bandpass filter (3) exhibits symmetrical characteristics with respect to the first and second connection (26, 27).

10. Switchable bandpass filter (3) according to one of claims 1 to 9,
**characterised in that** line sections of the first and the second filter elements (22, 24) are bent back so that in each case four microstrip line sections (402, 406, 407,411, 422, 426, 427, 431) which are parallel to one another in pairs are formed in each filter element.

11. Switchable bandpass filter (3) according to one of claims 1 to 10,
**characterised in that** the line sections (903 - 906) of the first and the second filter elements (22, 24) are arranged alternately parallel to one another and in each case the line sections (903, 905; 904, 906) are connected in electrically conducting fashion at one end.

12. Switchable bandpass filter (3) according to claim 11,
**characterised in that** the first and the second filter elements (22, 24) in each case exhibit a further line section (911, 912) suitable for tuning the filter frequency.

13. Switchable bandpass filter (3) according to one of claims 12 to 13,
**characterised in that** the first and the second filter elements (22, 24) are arranged on different layers of the printed circuit board.

## Revendications

1. Filtre passe-bande commutable (3), comportant un premier élément de filtre (22), un second élément de filtre (24), qui sont couplés l'un à l'autre par l'intermédiaire d'un dispositif de couplage commutable (23),
**caractérisé en ce que**
le premier et le second élément de filtre (22, 24) présentent respectivement une structure conductrice réalisée en surface dans un plan, qui comprend respectivement au moins deux tronçons de ligne, dans lequel le premier et le second élément de filtre (22, 24) se trouvent conjointement en une interaction électromagnétique directe dans au moins un tronçon respectif s'étendant linéairement des tronçons de ligne (406/426, 411/413, 903-906).

2. Filtre passe-bande commutable (3) selon la revendication 1, **caractérisé en ce que**
le premier et le second élément de filtre (22, 24) sont constitués de lignes microruban reliées à l'un respectif à l'extrémité à la masse.

3. Filtre passe-bande commutable (3) selon la revendication 1 ou 2, **caractérisé en ce que**
le dispositif de couplage (23) formé à partir d'un réseau est constitué de diodes semi-conductrices et de condensateurs et/ou d'inducteurs.

4. Filtre passe-bande commutable (3) selon l'une des revendications 1 à 3, **caractérisé en ce que**
le dispositif de couplage (23) contient des diodes varactors ou des diodes pins.

5. Filtre passe-bande commutable (3) selon l'une des revendications 1 à 4, **caractérisé en ce que**
le filtre passe-bande (3) est réalisé sur une ou plusieurs cartes de circuits imprimés à plusieurs couches, et
dans lequel le premier et le second élément de filtre (22, 24) sont réalisés sur une ou plusieurs couches de la carte de circuits imprimés et le dispositif de couplage (23) et des circuits de commande sont réalisés sur une ou plusieurs autres couches.

6. Filtre passe-bande commutable (3) selon l'une des revendications 1 à 5, **caractérisé en ce que**
un premier et un second raccord (26, 27) du filtre passe-bande (3) sont réalisés respectivement sur un tronçon du premier élément de filtre (22) et du second élément de filtre (24).

7. Filtre passe-bande commutable (3) selon l'une des revendications 1 à 6, **caractérisé en ce que**
le dispositif de couplage (23) est réalisé de sorte que des condensateurs pouvant être raccordés au premier et au second élément de filtre (22, 24) sont respectivement de même taille pour le premier et le second élément de filtre (22, 24).

8. Filtre passe-bande commutable (3) selon l'une des revendications 1 à 7, **caractérisé en ce que**
le premier et le second élément de filtre (22, 24) sont réalisés symétriques l'un par rapport à l'autre.

9. Filtre passe-bande commutable (3) selon l'une des revendications 1 à 8, **caractérisé en ce que**
le filtre passe-bande (3) présente un comportement symétrique par rapport au premier et au second raccord (26, 27).

10. Filtre passe-bande commutable (3) selon l'une des revendications 1 à 9, **caractérisé en ce que**
des tronçons de ligne du premier et du second élément de filtre (22, 24) sont courbés de sorte qu'il en résulte quatre tronçons de ligne microruban parallèles l'un par rapport à l'autre deux par deux (402, 406, 407, 411, 422, 426, 427, 431).

11. Filtre passe-bande commutable (3) selon l'une des revendications 1 à 10, **caractérisé en ce que**
les tronçons de ligne (903-906) du premier et du second élément de filtre (22, 24) sont disposés parallèlement l'un par rapport à l'autre de façon alternée et les tronçons de ligne respectifs (903, 905 ; 904, 106) sont reliés de manière électriquement conductrice à une extrémité.

12. Filtre passe-bande commutable (3) selon la revendication 11, **caractérisé en ce que**
le premier et le second élément de filtre (22, 24) présentent respectivement un autre tronçon de ligne (911, 912) adapté pour un accord de la fréquence de filtre.

13. Filtre passe-bande commutable (3) selon l'une des revendications 12 à 13, **caractérisé en ce que**
le premier et le second élément de filtre (22, 24) sont disposés sur différentes couches de la carte de circuits imprimés.
